(19) Europäisches Patentamt
European Patent Office
Office européen des brevets

(11) **EP 3 533 145 B1**

(12) **EUROPEAN PATENT SPECIFICATION**

(45) Date of publication and mention
of the grant of the patent:
**06.04.2022 Bulletin 2022/14**

(21) Application number: **16838092.1**

(22) Date of filing: **21.11.2016**

(51) International Patent Classification (IPC):
$H03M\ 13/03^{(2006.01)}$     $H03M\ 13/11^{(2006.01)}$

(52) Cooperative Patent Classification (CPC):
**H03M 13/036; H03M 13/1154; H03M 13/116**

(86) International application number:
**PCT/RU2016/000799**

(87) International publication number:
**WO 2018/093286 (24.05.2018 Gazette 2018/21)**

(54) **GENERATION OF SPATIALLY-COUPLED QUASI-CYCLIC LDPC CODES**

ERZEUGUNG VON SPATIALLY-COUPLED QUASI-ZYKLISCHEN LDPC CODES

GÉNÉRATION DE CODES LDPC QUASI-CYCLIQUES COUPLÉS SPATIALEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.09.2019 Bulletin 2019/36**

(73) Proprietor: **Huawei Technologies Co., Ltd.
Longgang District
Shenzhen, Guangdong 518129 (CN)**

(72) Inventor: **USATYUK, Vasily Stanislavovich
Shenzhen
Guangdong 518129 (CN)**

(74) Representative: **Pfenning, Meinig & Partner mbB
Patent- und Rechtsanwälte
Theresienhöhe 11a
80339 München (DE)**

(56) References cited:
WO-A1-2013/047258     US-A1- 2013 086 456
US-A1- 2016 233 979

- YIGE WANG ET AL: "Hierarchical and High-Girth QC LDPC Codes", IEEE TRANSACTIONS ON INFORMATION THEORY, vol. 59, no. 7, 1 July 2013 (2013-07-01), pages 4553-4583, XP055394292, USA ISSN: 0018-9448, DOI: 10.1109/TIT.2013.2253512

- LAU FRANCIS C M ET AL: "Novel types of cyclically-coupled quasi-cyclic LDPC block codes", PROC., IEEE INTERNATIONAL CONFERENCE ON ADVANCED TECHNOLOGIES FOR COMMUNICATIONS, ATC, 12 October 2016 (2016-10-12), pages 27-31, XP033015949, DOI: 10.1109/ATC.2016.7764787 [retrieved on 2016-12-01]

- HUA ZHOU ET AL: "Cycle analysis of time-invariant LDPC convolutional codes", PROC., IEEE 17TH INTERNATIONAL CONFERENCE ON TELECOMMUNICATIONS (ICT), 2010, 4 April 2010 (2010-04-04), pages 23-28, XP031685444, ISBN: 978-1-4244-5246-0

- HUA ZHOU ET AL: "Girth analysis of polynomial-based time-invariant LDPC convolutional codes", PROC., IEEE 20TH INTERNATIONAL CONFERENCE ON SYSTEMS, SIGNALS AND IMAGE PROCESSING, IWSSIP, 11 April 2012 (2012-04-11), pages 104-108, XP055393341, ISSN: 2157-8672

- Vasily; Usatyuk: "Some problems of Graph Based Codes for Belief Propagation decoding Quasi-cyclic Low Density Parity-check code (QC-LDPC)", , 24 November 2015 (2015-11-24), XP055302971, Retrieved from the Internet: URL:https://arxiv.org/ftp/arxiv/papers/1511/1511.00133.pdf [retrieved on 2016-09-15]

- **YIGE WANG ET AL: "Construction of high-girth QC-LDPC codes", PROC., 5TH IEEE INTERNATIONAL SYMPOSIUM ON TURBO CODES AND RELATED TOPICS, 2008, 1 September 2008 (2008-09-01), pages 180-185, XP031353684, ISBN: 978-1-4244-2862-5**

**Description**

**TECHNICAL FIELD**

The present invention relates to the field of channel coding. More specifically, the invention relates to devices and methods for generating a low density parity check (LDPC) code.

**BACKGROUND**

Error-correcting coding is an efficient method of approaching the capacity of a communication system. LDPC codes, which constitute one class of error correcting codes, have been introduced in 1962. Due to the limitation in computational effort in implementing the coder and decoder for such codes and the introduction of Reed-Solomon codes, LDPC codes have been ignored for almost 30 years. During that long period, the only notable work done on the subject was a generalization of LDPC codes and the introduction of a graphical representation of these codes, which is referred to as Tanner graph. Since 1993, with the introduction of turbo codes, researchers switched their focus to finding low complexity codes which can approach the Shannon channel capacity.

It is well known that the performance of randomly constructed irregular LDPC codes closely approach the Shannon limit for the additive white Gaussian noise (AWGN) channel as the code length becomes larger. Moreover, it has been shown that it is possible for irregular LDPC codes with a block length of $10^7$ to come very close (i.e. 0.0045 dB) to the Shannon capacity.

Although a randomly constructed LDPC code shows a good asymptotic performance, its randomness hinders the ease of analysis and implementation. In attempts towards an algebraic construction of LDPC codes, a quasi-cyclic (QC) LDPC code has been receiving increased attention, because it can be encoded in linear-time with shift registers and a small size of required memory.

With the increasing demand for applications requiring high data rates, many recent communication systems employ ultra-high throughput QC-LDPC codes to match the data-rate requirements, such as those posed by the next generation or 5G wireless communication systems.

Spatially-Coupled LDPC codes show excellent performance under moderate to high lengths and rates as well as simple structures, which reduce the complexity of analysis, design, and hardware implementation for rate and length adapted codes. These properties of SC-LDPC codes offer attractive possibilities for future coding standards.

US 2015/0155884 A1 discloses an example of designing a base matrix of a SC-LDPC code using an algebraic approach. More specifically, US 2015/0155884 A1 discloses an algebraic approach for generating a SC-LDPC code on the basis of a multiplicative group using the approach disclosed in R. M. Tanner, D. Sridhara, A. Sridharan, T. E. Fuja and D. J. Costello, "LDPC block and convolutional codes based on circulant matrices," in IEEE Transactions on Information Theory, vol. 50, no. 12, pp. 2966-2984, Dec. 2004. Yige Wang et al.:"Hierarchical and High-Grith QC LDPC codes"; IEEE Transactions on Information Theory, vol 59, no. 7; 1 July 2013, pages 4553-4583, addresses hierarchical and high-grith QC LDPC codes. Lau, Francis C. M, et al.: "Novel types of cyclically-coupled quasi-cyclic LDPC block codes"; Proc. IEEE International Conference on Advanced Technologies for Communication; ATC, 12 October 2016, pages 27-31, discusses novel types of cyclically-coupled quasi-cyclic LDPC block codes. Time-invariant LDPC convolutional codes are subject of a cycle analysis in Hou Zhou et al.: "Cycle analysis of time-invariant LDPC convolutional codes" Proc. 17th International Conference on Telecommunications (ICT) 2010, 4 April 2010, pages 23 to 28.

US 8103 931 B2 discloses a method comprising graph lifting of a base matrix using a hill-climbing technique. Further prior art useful for understanding the current invention is disclosed in US2016/233979 A1 and WO 2013/047258 A1.

In light of the above, there is a need for improved devices and methods for generating LDPC codes.

**SUMMARY**

It is an object of the invention to provide devices and methods for generating LDPC codes.

The foregoing and other objects are achieved by the subject matter of the independent claims. Further implementation forms are apparent from the dependent claims, the description and the figures.

According to a first aspect the embodiments of the invention relates to an apparatus for providing at least one parity check matrix defining a spatially-coupled low density parity check, LDPC, code on the basis of a set of base matrix parameters defining a plurality of base matrices, each base matrix of the plurality of base matrices being associated with a protograph of a plurality of protographs, wherein the set of base matrix parameters defines the size WxC, a circulant size N, a maximal column weight M and a set of allowed column weights of the plurality of base matrices, wherein the apparatus comprises: a processor configured to: generate on the basis of the plurality of protographs a set of candidate protographs by discarding protographs of the plurality of protographs; lift the protographs of the set of candidate protographs for generating a plurality of codes; and generate on the basis of a plurality of codes a set of candidate codes by discarding codes of the plurality of codes, wherein the processor is configured to lift the protographs of the set of candidate protographs on the basis of a simulated annealing technique.

In a first possible implementation form of the apparatus according to the first aspect as such, the processor is configured to discard those protographs of the plurality of protographs that are associated with a LDPC code having a minimum Hamming distance that is larger than a minimum Hamming distance threshold value.

In a second possible implementation form of the apparatus according to the first implementation form of the first aspect, the processor is configured to estimate the minimum hamming distance of a LDPC code C on the basis of the upper bound defined by the following equation:

$$d_{min}(C(H)) \leq \min_{\substack{S \subseteq \subseteq [W] \\ |S|=C+1}}^{+} \sum_{i \in S} perm(A_{S \setminus i})$$

wherein

[W] denotes the set of numbers from [0... $W$ - 1],
the operator min⁺(...) defines the minimal positive value of its argument, and the permanent operator *perm*(...) is defined by the following equation:

$$perm(B) = \sum_{\sigma} \prod_{j \in [m]} b_{j,\sigma(j)}$$

wherein

$B$ is a $m \times m$ matrix having elements $b_{j,\sigma(j)}$ and
$\sigma$ takes all $m$! possible permutations of the set [$m$].

In a third possible implementation form of the apparatus according to the first or second implementation form of the first aspect, the minimum Hamming distance threshold value is (C+1)!.

In a fourth possible implementation form of the apparatus according to the first aspect as such or any one of the first to third implementation form thereof, the processor is further configured to discard protographs of the plurality of protographs on the basis of the balanced girth of the parity check matrix H associated with each protograph.

In a fifth possible implementation form of the apparatus according to the fourth implementation form of the first aspect, the processor is configured to discard those protographs from the plurality of protographs that are associated with a parity check matrix H having a balanced girth which is larger than a balanced girth threshold value.

In a sixth possible implementation form of the apparatus according to the first aspect as such or any one of the first to fifth implementation form thereof, the processor is further configured to lift a protograph of the plurality of protographs having at least one parallel edge to a protograph having no parallel edges.

In a seventh possible implementation form of the apparatus according to the first aspect as such or any one of the first to sixth implementation form thereof, the processor is further configured to discard those protographs of the plurality of protographs that are associated with an extrinsic message degree (EMD) that is smaller than an EMD threshold value.

According to a second aspect the embodiments of the invention relates to a corresponding method for providing at least one parity check matrix defining a spatially-coupled low density parity check, LDPC, code on the basis of a set of base matrix parameters defining a plurality of base matrices, each base matrix of the plurality of base matrices being associated with a protograph of a plurality of protographs, wherein the set of base matrix parameters defines the size WxC, a circulant size N, a maximal column weight M and a set of allowed column weights of the plurality of base matrices, wherein the method comprises the steps of: generating on the basis of the plurality of protographs a set of candidate protographs by discarding protographs of the plurality of protographs; lifting the protographs of the set of candidate protographs for generating a plurality of codes; and generating on the basis of a plurality of codes a set of candidate codes by discarding codes of the plurality of codes, wherein the step of lifting the protographs of the set of candidate protographs is based on a simulated annealing technique.

The method according to the second aspect of the embodiments of the invention can be performed by the apparatus according to the first aspect of the embodiments of the invention. Further features of the method according to the second aspect of the embodiments of the invention result directly from the functionality of the apparatus according to the first aspect of the embodiments of the invention and its different implementation forms.

According to a third aspect the embodiments of the invention relates to a computer program comprising program code for performing the method according to the second aspect of the embodiments of the invention when executed on a computer.

The embodiments of the invention can be implemented in hardware and/or software.

**BRIEF DESCRIPTION OF DRAWINGS**

Further embodiments of the invention will be described with respect to the following figures, wherein:

Fig. 1 shows a schematic diagram illustrating an apparatus for generating a LDPC code according to an embodiment;
Fig. 2 shows a schematic diagram illustrating an exemplary block of circulants shifted by two different values;
Fig. 3 shows a schematic diagram illustrating an exemplary spatially coupled parity-check matrix represented by blocks of circulants;
Fig. 4 shows a schematic diagram of exemplary blocks of circulant permutation matrices and spatially coupled blocks of circulant permutation matrices;
Fig. 5 shows a schematic diagram of an exemplary protograph having a trapping set;
Fig. 6a shows a schematic diagram illustrating a protograph selection or optimization stage of the code generation according to an embodiment;
Fig. 6b shows a schematic diagram illustrating a protograph lifting optimization stage of the code generation according to an embodiment;
Fig. 7 shows a schematic diagram illustrating two exemplary protographs with two cycles having the same ACE value and different EMD values;
Fig. 8a shows a schematic diagram illustrating an exemplary cycle in a protograph having a left edge intersecting shifted zone;
Fig. 8b shows a schematic diagram illustrating an exemplary cycle in a protograph having no closed cycle in the spatially coupled graph;
Fig. 9 shows a schematic diagram illustrating an exemplary 4VN subgraph of a protograph;
Fig. 10a shows a diagram illustrating the performance of codes provided by embodiments of the invention in comparison with conventional codes;
Fig. 10b shows a diagram illustrating the performance of codes provided by embodiments of the invention in comparison with conventional codes;
Fig. 11a shows a diagram illustrating the performance of codes provided by embodiments of the invention in comparison with conventional codes; and
Fig. 11b shows a diagram illustrating the performance of codes provided by embodiments of the invention in comparison with conventional codes.

In the various figures, identical reference signs will be used for identical or at least functionally equivalent features.

**DESCRIPTION OF EMBODIMENTS**

In the following description, reference is made to the accompanying drawings, which form part of the disclosure, and in which are shown, by way of illustration, specific aspects in which the present invention may be placed. It is understood that other aspects may be utilized and structural or logical changes may be made without departing from the scope of the present invention. The following detailed description, therefore, is not to be taken in a limiting sense, as the scope of the present invention is defined be the appended claims.

For instance, it is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

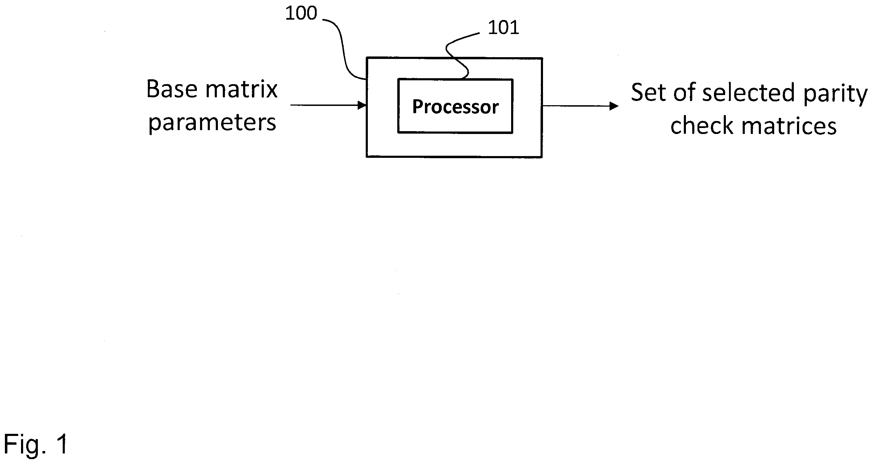

Figure 1 shows a schematic diagram illustrating an apparatus 100 for providing a parity check matrix defining a spatially-coupled low density parity check, LDPC, code on the basis of a base matrix defining a quasi-cyclic LDPC code. The apparatus 100 comprises a processor 101 configured to: generate on the basis of a plurality of protographs associated with the base matrix a set of candidate protographs by discarding protographs of the plurality of protographs; lift the protographs of the set of candidate protographs for generating a plurality of codes; and generate on the basis of a plurality of codes a set of candidate codes by discarding codes of the plurality of codes.

The processor 101 is configured to lift the protographs of the set of candidate protographs on the basis of a simulated annealing technique, as will be described in more detail further below.

Before describing some further details of the apparatus 100 shown in figure 1 and different embodiments thereof, the following "background material" is provided for a better understanding of different embodiments of the apparatus 100.

A (W,C,N,L) tail-bitten spatially-coupled QC-LDPC code $C(H)$ of length W multiple L multiple N (i.e. if the circulant size is NxN with W circulants coupled L times) can be defined by a parity-check base matrix $H$ in the following way:

$$H = \begin{bmatrix} A_{0,0} & A_{1,0} & \cdots & A_{WL-1,0} \\ A_{0,1} & A_{1,1} & & A_{WL-1,1} \\ \mathbf{M} & \mathbf{M} & \mathbf{O} & \mathbf{M} \\ A_{0,CL-1} & A_{1,CL-1} & \cdots & A_{WL-1,CL-1} \end{bmatrix} \qquad (1)$$

wherein $0 \le i \le CL - 1$, $1 \le j \le WL\text{-}1$ and a circulant permutation matrix (CPM) $A_{i,j}$ represents either the $N \times N$ zero matrix Z or the $N \times N$ circulant permutation matrix $I(p_{i,j})$ obtained by cyclically right-shifting the $N \times N$ identity matrix $I(0)$ by $p_{i,j}$ positions. Denote by CPM-column the i-th column of $A_{0,i}, A_{1,i}, ..., A_{CL-1,i}$. In a similar way define CPM-row.

For a specific tail-bitten spatially-coupled QC-LDPC code the corresponding CPM-shifts matrix can be defined as the matrix of circulant shifts that defines the QC-LDPC code, i.e.:

$$B = \begin{bmatrix} b_{0,0} & b_{1,0} & \cdots & b_{W-1,0} \\ b_{0,1} & b_{1,1} & & b_{W-1,1} \\ \mathbf{M} & \mathbf{M} & \mathbf{O} & \mathbf{M} \\ b_{0,C-1} & b_{1,C-1} & \cdots & b_{W-1,C-1} \end{bmatrix} \qquad (2)$$

The corresponding shifts can be represented as a vector $D$ of shifts:

$$D = \begin{bmatrix} d_0 \\ d_1 \\ \mathbf{M} \\ d_{C-1} \end{bmatrix} \qquad (3)$$

with the conditions $d_0 = 0, d_i < d_j$ iff $i < j$, $\forall i\ d_i < W$. If $\dfrac{W}{C}$ is an integer, the vector $D$ can be defined as $d_i = \dfrac{i\,W}{C}$.

For $0 \le i \le CL - 1$, $0 \le j \le WL\text{-}1$, if
$i'$ mod $WL \le i < (i' + W)$ mod $WL$
then $A_{i,j} = I(b_i \bmod_W j \bmod c)$ else $A_{i,j} = Z$.

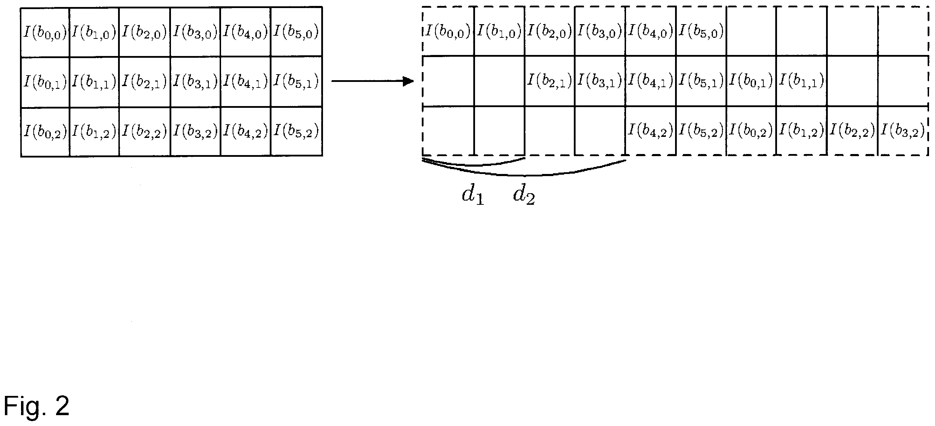

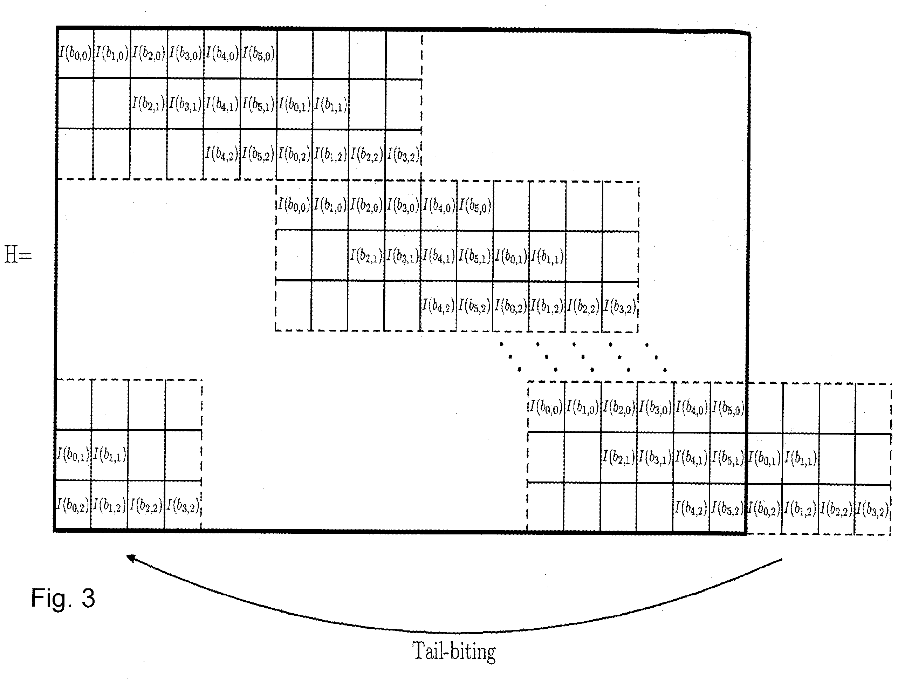

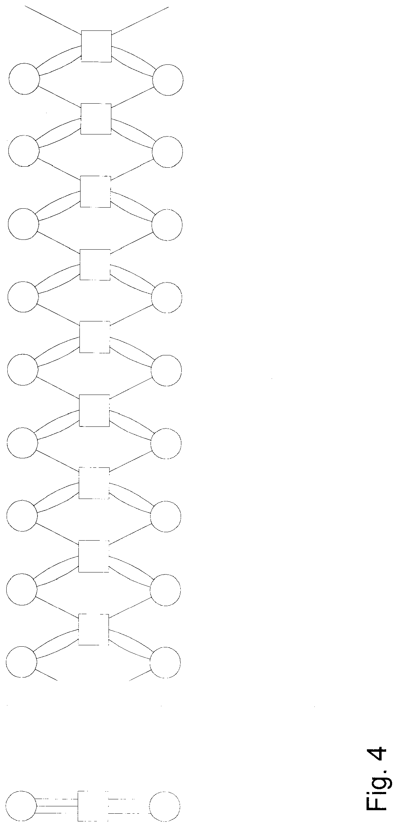

The above definitions are further illustrated by figures 2 to 4. Figure 2 shows a schematic diagram illustrating an exemplary block of circulants shifted by two different values. Figure 3 shows a schematic diagram illustrating a spatial coupled parity-check matrix represented by blocks of circulants. Figure 4 shows a schematic diagram of a blocks of circulant permutation matrices and spatially coupled blocks of circulant permutation matrices.

There is a more general case of parity check matrices, where one circulant permutation matrix can have more than one diagonal.

A weight matrix (or protograph) wt(H) of a matrix H is a matrix of number of diagonals for each circulant of H.

A type M of the matrix H is a maximal value of the matrix wt(H).

Given a protograph matrix H of type $M > 1$, a matrix with circulant size equal to M can be generated. Choosing in each circulant the number of diagonals equal to corresponding weight, the result can be considered as a new protograph matrix H'. The type of the new protograph matrix H' is 1, and most properties of H' will remain the same as for H. Thus, without loss of generality only protograph matrices of type 1 can be considered, when it is necessary.

There is isomorphism between the ring of circulant permutation matrices over some field **F** and the ring **F**-polynomials modulo $x^N$ - 1, where N is the size of the circulant. For example $I(0)$ can be represented as $x^0$, $I(5)$ as $x^5$, and $I(0) + I(1) + I(4)$ as $x^0 + x^1 + x^4$.

A very important characteristic of a parity check matrix is the girth of its Tanner graph, which is defined as the minimal length of a cycle of the Tanner graph of a parity check matrix. A cycle in a Tanner graph can be defined in the following way: ...

Cycle of even length 2K in H defined by 2K positions of ones such that:

1) Two consecutive positions are obtained by changing alternatively column of row only;
2) All positions are distinct except first and last one;

Two consecutive elements of the path belong to different circulant permutation matrices. Thus, a chain of circulant permutation matrices can be defined as follows:

$$A_{i_0,j_0}, A_{i_0,j_1}, A_{i_1,j_1}, A_{i_1,j_2}, \dots A_{i_{K-1},j_{K-1}}, A_{i_{K-1},j_0}, A_{i_0,j_0} ,$$

where $i_a \neq i_{a+1}, j_a \neq j_{a+1}$, for all $0 \leq a \leq K$ - 1.

As each part of a cycle is one, a circulant permutation matrix $A_{i,j}$ participating in the cycle cannot be empty. In other words, $A_{i,j} = I(p_{i,j})$.

Using these shifts of the identity matrix the necessary and sufficient conditions for the existence of the cycle can be expressed as follows:

$$\sum_{a=0}^{K-1} p_{i_a,j_a} - p_{i_a,j_{a+1}} \equiv 0 \ (mod \ N) \qquad (4)$$

The Tanner graph T(H) of a parity check matrix H is a bipartite graph with two set of vertices, referred to as variable nodes $V = \{v_0, v_1, ..., v_{n-1}\}$ and check nodes $C = \{c_0, c_1, ..., c_{n-1}\}$. The columns of the matrix H correspond to the variable nodes, and the rows thereof to the check nodes. There is an edge between a variable node $v_i$ and a check node $c_j$, if any only if the cell of H at the i-th column and the j-th row is nonzero.

A trapping set $T$ of type ($T_1$, $T_2$) is a connected subgraph of a Tanner graph, including $T_1$ variable nodes, where $T_2$ check nodes are connected with the trapping set $T$ by an odd number of edges.

Simultaneously altering values of $T_1$ variable nodes and $T_2$ check nodes gives correct result. It means that wrong bit in $T_2$ check nodes gives wrong decoding of $T_1$ variable nodes. A small value of $T_2$ gives bad trapping sets, as it more easy to make mistakes in a small number of nodes. Trapping sets with bigger value of $T_2$ are worse as more informational bits are wrong. Differently put, if wrong bit place to variable nodes incident to odd degree check node, then Belief Propagation decoder most commonly fails due to this error (even if the code distance is greater than this number error). The graph properties are the reason for this error.

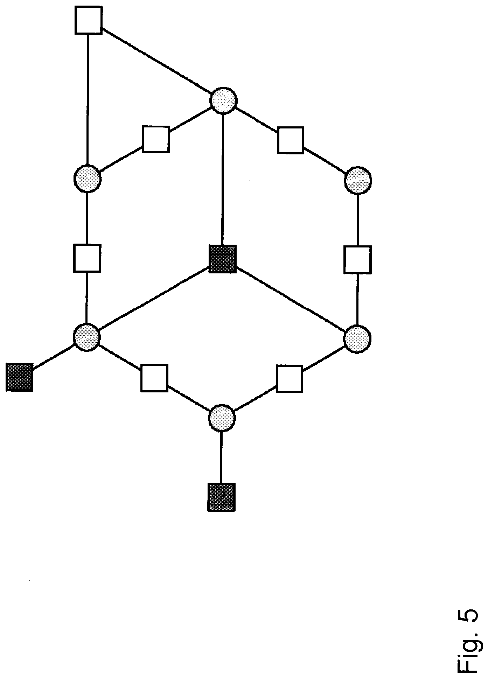

Figure 5 shows a schematic diagram of an exemplary protograph having a trapping set.

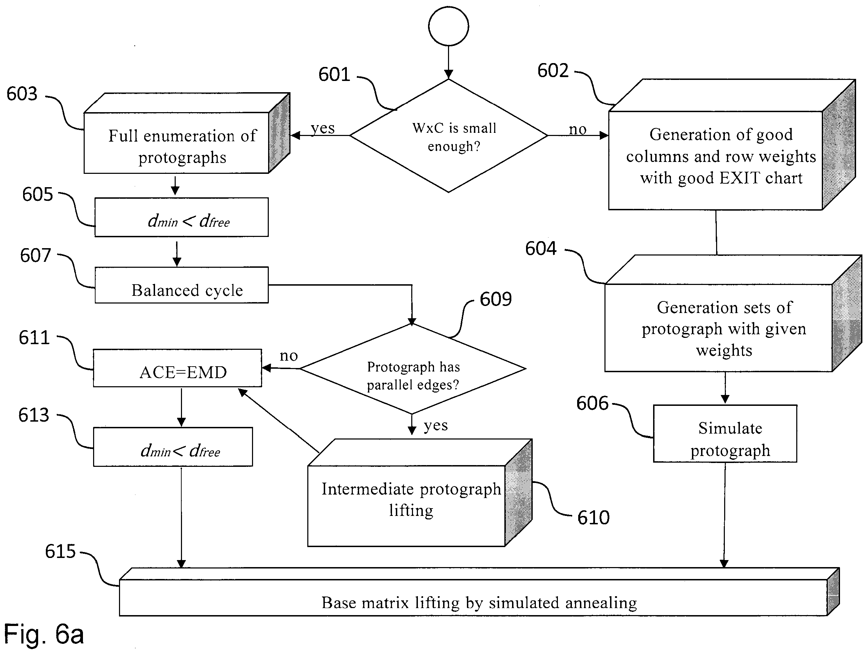

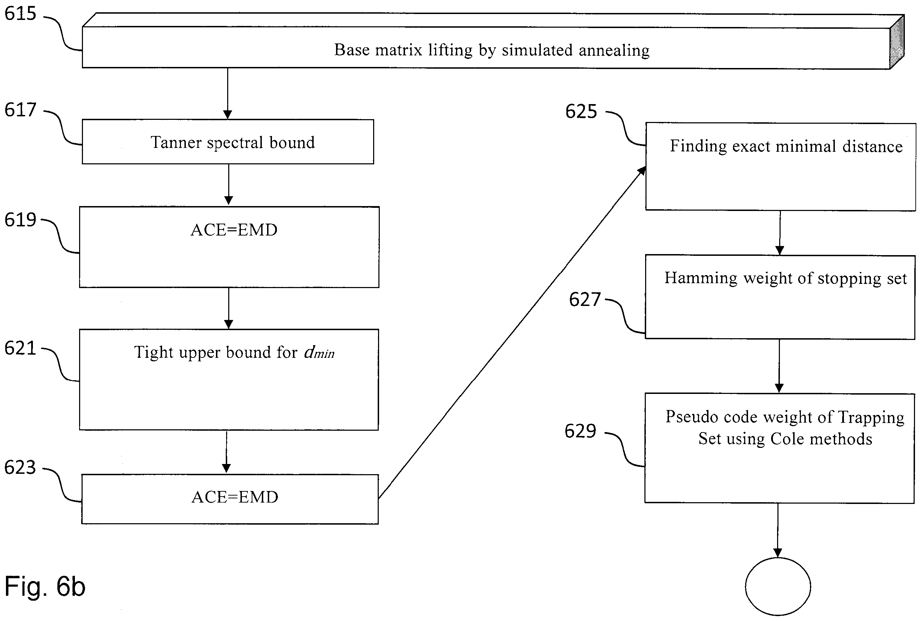

Figure 6a shows a schematic diagram illustrating a protograph selection or optimization stage of the code generation provided by the apparatus 100 according to an embodiment. Figure 6b shows a schematic diagram illustrating a protograph lifting stage and subsequent code selection stage of the code generation provided by the apparatus 100 according to an embodiment.

In an embodiment, the input of the code generation stages shown in figures 6a and 6b are the parameters of a base matrix, namely its size WxC (e.g. 32x16), a circulant size N, a maximal column weight M and a set of allowed column weights. As will be explained in more detail below, the final output of the code generation stages shown in figures 6a and 6b is a set of selected parity check matrices providing good LDPC codes.

The code generation stages shown in figures 6a and 6b comprises generator blocks (indicated as three-dimensional processing blocks in figures 6a and 6b) and filter or selection blocks (indicated as two-dimensional processing blocks in figures 6a and 6b). Each generator block is configured to generate either a protograph or a parity check matrix (based on the given protograph). Each filter or selection block filters its input in some way and, thereby, performs a selection operation on the basis of its input.

The first stage shown in figure 6a illustrates two branches, namely a first branch which generates protographs in processing block 603, when the input base matrix is smaller than a predefined threshold (i.e. when the search is not too complex) and a second branch which comprises processing blocks 602, 604 and 606, when the base matrix is larger than a predefined threshold (for example, for estimating an upper bound on the code distance it is may necessary to enumerate 1.1826e+17 permanents for a base matrix 30x60 and permanents of size 30x30).

In the following several of the processing blocks shown in figures 6a and 6b and implemented in an embodiment of the apparatus 100 will be described in more detail.

In the processing step 603, the processor 101 of the apparatus 100 is configured to consider possible protograph matrices for a given length N and rate K/N. If K and N are not too large enough, the processor 101 can enumerate all protographs.

In an embodiment, the processor 101 is configured to estimate in the next processing step 605 the quality of a QC-LDPC code based on a protograph $A$ by estimating the minimum Hamming distance of the code.

The permanent of the $m \times m$ base matrix B is

$$perm(B) = \sum_{\sigma} \prod_{j \in [m]} b_{j,\sigma(j)}$$

where $\sigma$ takes all $m!$ possible permutations of the set $[m]$. The function $min^+()$ denotes minimal positive value and $[\mathbf{W}]$ denotes the set of numbers from $[0 \ldots W - 1]$. Then, the upper bound $d_{min}$ for QC code $C(H)$ with polynomial parity-check matrix can be expressed in the following way:

$$d_{min}(C(H)) \leq \min_{\substack{S \subseteq \subseteq [\mathbf{W}] \\ |S|=C+1}}^{+} \sum_{i \in S} perm(A_{S \setminus i}) \qquad (5)$$

According to an embodiment, the processor 101 is configured to further process a code if the upper bound $d_{min}$ is not less than (C+1)! in the processing block 605. In other words, in the processing block 605 the processor 101 is configured to discard protographs or corresponding codes with an upper bound $d_{min}$ being smaller than (C+1)!.

The following example illustrates the use of equation (5), as applied by the processor 101 in embodiments of the invention. Consider two (2,4) regular length-4r QC codes, namely a first code $C(H_1)$ with parity check matrix

$$H_1(x) = \begin{pmatrix} x & x^2 & x^4 & x^8 \\ x^5 & x^6 & x^3 & x^7 \end{pmatrix},$$

and a second code $C(H_2)$ with parity check matrix

$$H_2(x) = \begin{pmatrix} x & x^2 & x^4 & x^8 \\ x^6 & x^5 & x^3 & x^9 \end{pmatrix}.$$

For both codes equation (5) provides:

$$d_{min} \leq min^+\{(1+1) + (1+1) + (1+1)\} = 6$$

$$\sum_{a=0}^{K-1} p_{i_a,j_a} - p_{i_a,j_{a+1}} \equiv 0 \ (mod \ N) \qquad (4)$$

In above equation (4) each coefficient $p_{i,j}$ for the CPM $A_{i,j}$ adds with plus for each even step and with minus for each odd steps. If the number of even steps for the CPM $A_{i,j}$ equals the number of odd steps, then $p_{i,j}$ can be eliminated from above equation (4).

A balanced cycle on the parity check matrix H is the cycle where each cell participates the same number of times in even steps and in odd steps. For a balanced cycle above equation (4) reduces to the trivial equality $0 \equiv 0$, which holds for any values of coefficients $p_{i,j}$.

In the processing block 607 the processor 101 is configured to estimate the minimal length of the balanced cycle for each protograph candidate.

The balanced girth is defined as the minimal length of the balanced cycle. The actual girth cannot be larger than the balanced girth of a parity check matrix H for any shifts of circulant permutation matrices. For this reason, the balanced girth is an important upper bound for the girth of a protograph, as implemented in embodiments of the invention.

In the following, a pseudo code for estimating the balanced girth of the parity check matrix H will be described, as implemented in embodiments of the invention. Here, K denotes a pre-defined constant. This pre-defined constant can be selected as a trade-off. After a certain value of balance cycle, the code distance can become too bad. Thus, the pre-defined constant can be selected as the point, where the cycle is enough to prevent performance degradation by TS and code distance.

Enumerate all closed cycles with length shorter than given K, going through non-empty protograph cells, with vertical lines on even steps, and horizontal lines on odd steps.

1. For each cycle from enumeration calculate whether this cycle is balanced or not.

   a. For each cell of the cycle calculate difference between the appearance after even and after odd steps.
   b. The cycle is balanced, if and only if all differences are zero.

2. Return minimal length of the balanced cycle.

In processing block 609, the processor 101 is configured to determine for each candidate protograph, whether the protograph has parallel edges. If this is the case, the processor 101 is configured to lift in processing block 610 a corresponding candidate protograph A having some parallel edges to a bigger protograph without parallel edges using a quasi-cyclic technique. For a protograph of type K, the minimal possible value of the circulant size K is chosen and changed for each.

In processing block 611, the processor 101 is configured to discard protographs having a small Extrinsic Message Degree (EMD), i.e. an EMD smaller than a predefined threshold. The EMD of a cycle in the Tanner graph is defined as the number of check nodes singly connected to the variable nodes involved in the cycle. The EMD value of a code is an important characteristic, because each cycle $C_{2n}$ of length 2n is a trapping set $(n, EMD(C_{2n}))$.

The Approximate Cycle EMD (ACE) is defined as the number of incident edges not included in the cycle. For a cycle $C_{2n}$ of length 2n the following relation holds

$$\sum_{k=1}^{2n} ACE(C_{2n}) = (d_{v_k} - 2),$$

where $d_{v_k}$ denotes the degree of k-th variable node.

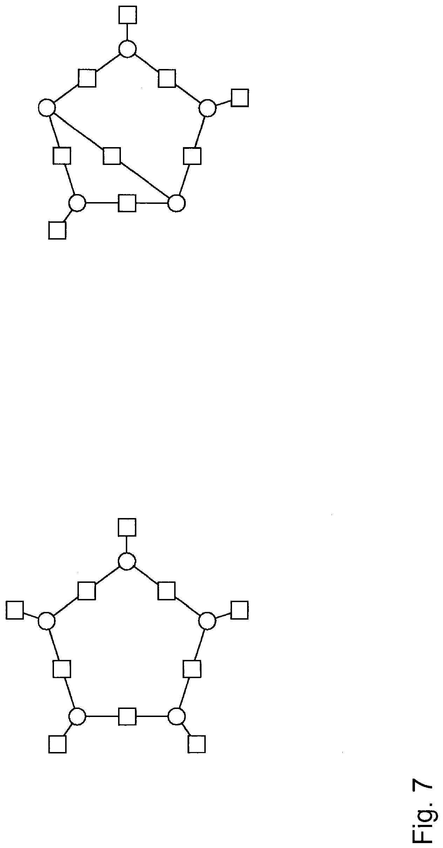

Figure 7 shows a schematic diagram illustrating two protographs with two cycles having the same ACE value, namely ACE=5, and different EMD values, namely EMD=5 for the protograph on the left and EMD=3 for the protograph on the right.

The ACE spectrum $\mu_{ACE} = (\mu_2, \mu_4, ..., \mu_{d_{ACE}})$ of a Tanner graph is defined as the set of minimum ACE values of a given length range from 2 up to $d_{ACE}$ of the graph. If there are no cycles of length k, then $\mu_k = \infty$.

It has been shown that the ACE and the EMD value(s) can be related in the following ways.

First, for a code with a girth g the following relation holds for a cycle $C_k$ having a length $k < 2g - 4$: $ACE(C_k)=EMD(C_k)$.

Second, for a code with the girth g and the ACE spectrum $\mu_{ACE} = (\mu_2, \mu_4, ..., \mu_{d_{ACE}})$, $ACE(C_k)$ of the cycle $C_k$ of length k, $k \geq 2g - 4$ is equal to $EMD(C_k)$ if

$$ACE(C_k) < \min_{j \in \{g, g+2, ..., k+4-g\}} \frac{\mu_j + \mu_{k-j+4}}{2}$$

These relations between the ACE and the EMD are illustrated by the following examples.

For a LDPC code of girth 12, all the cycles of length 12, 14, 16 and 18 have equal ACE and EMD.

For a LDPC code with ACE spectrum $(\infty, \infty, 15,11,16)$ all the cycles of length 8 with the ACE value less than 13 will have equal ACE and EMD.

For all cycles of length 10 and ACE value less than $13 = \frac{15+11}{2}$.

In an embodiment, the processor 101 is configured to make use of one or more of the above relations between the ACE and the EMD in the processing block 611 for a fast evaluation of the EMD for cycles in protographs. This, in turn, allows the processor 101 to estimate the number of trapping sets and, thus, the quality of a protograph in the processing block 611.

In an embodiment, for a given protograph the following assumptions are made: non-existence of cycles and hence a Gaussian distribution for LLR on the belief propagation algorithm. On the basis of these assumptions the decoding threshold of an ensemble of protographs characterized by a given distribution of variable nodes and check nodes can be calculated, as implemented in embodiments of the present invention.

We plot chart of two EXIT functions $I_{E,V}$ and $I_{E,C}$.

The step function shows the growth of the information obtained by the belief propagation algorithm. If the EXIT functions are not intersecting, the belief propagation algorithm can be terminated. The decoding threshold can be defined as the value of the noise, when the two EXIT functions touch each other. The two EXIT functions $I_{E,V}$ and $I_{E,C}$ can be expressed in the following way:

$$I_{E,V} = J(\sigma) = J\left(\sqrt{(d_v - 1)\sigma_A^2 + \sigma_{ch}^2}\right)$$

$$J(\sigma) = 1 - \int_{-\infty}^{\infty} \frac{1}{\sqrt{2\pi}\sigma} e^{-(l-\frac{\sigma^2}{2})^2/2\sigma^2} \log(1 + e^{-l})dl$$

$$I_{A,V} = J(\sigma_A)$$

$$I_{E,V} = J(\sigma) = J\left(\sqrt{(d_v - 1)[J^{-1}(I_{A,V})]^2 + \sigma_{ch}^2}\right).$$

In an embodiment, the following approximation can be used for $I_{E,C}$:

$$I_{E,C} = 1 - J\left(\sqrt{(d_c - 1)[J^{-1}(1 - I_{A,C})]^2}\right).$$

For irregular LDPC codes $I_{E,V}$ and $I_{E,C}$ can be calculated as weighted averages, as implemented in an embodiment of the invention.

In an embodiment, the weighting is given by the coefficients of the edge degree distribution polynomials $\lambda(z) = \sum_{d=1}^{d_v} \lambda_d z^{d-1}$ and $\rho(z) = \sum_{d=1}^{d_c} \rho_d z^{d-1}$, where $\lambda_d$ is the fraction of ones in the columns in the protograph with d ones in the column, and $\rho_d$ is the fraction of ones in the rows in the protograph with d ones in the row. For irregular LDPC codes this results in:

$$I_{E,V} = \sum_{d=1}^{d_v} \lambda_d I_{E,V}(d, I_{A,V})$$

$$I_{E,C} = \sum_{d=1}^{d_v} \rho_d I_{E,C}(d, I_{A,C})$$

In an embodiment, a pre-calculated approximation function $J(\cdot)$ can be used having an accuracy of, for instance, better than $10^{-5}$.

On the basis of the weighted functions $I_{E,V}(d, I_{A,V})$ and $I_{E,C}(d, I_{A,C})$ the processor 101 can be configured to calculate the following iterations:

$$I_{A,V}^{(0)} = 0$$

$$I_{A,V}^{(n+1)} = I_{E,C}(d, I_{E,V}(d, I_{A,V}^{(n)}))$$

In an embodiment, the processor 101 is configured to stop the iteration, when $I_{A,V}^{(n)}$ is close to 1.

For each distribution of weights $\lambda_d, \rho_d$ the minimal $\frac{E_b}{N_0}$ (based on $\sigma_A^2$) is calculated, when the iteration converges to 1 for a fixed number of steps.

Using EXIT charts, i.e. graphical representations of the exit functions, good distributions $\lambda_d, \rho_d$ can be generated and thereafter protographs with given distributions of ones in rows and columns can be created, as implemented in embodiments of the invention and as will be described in more detail in the following.

For each value of $\lambda_d$ the processor 101 is configured to generate a set of all possible columns, which provides this value $\lambda_d$. In an embodiment, parallel edges in the protograph are allowed, i.e. a cell can not only have the values 0 and 1, but larger values as well.

In an embodiment, the processor 101 is configured to generate protographs with given weights of rows using a backtracking algorithm. In this way, the processor 101 generates a set of protographs A possibly having a weight larger than 1. On the basis of this set of protographs *A* the processor 101 is configured to construct parity check matrices $H(x)$ with $wt(H(x)) = A$ (processing block 604 of figure 6a).

In an embodiment, a frame error rate (FER) threshold can be selected and the processor 101 is configured to perform the iterations of the belief propagation algorithm, until the smallest possible $\frac{E_b}{N_0}$ satisfying the FER threshold has been determined. From different codes we choose that one which provides a lower $\frac{E_b}{N_0}$.

In processing block 615, the processor 101 is configured to perform a base matrix lifting based on simulated annealing. To this end, a parameter K can be selected as the desired girth. In a first stage, a random initial parity check matrix can be generated by taking random values of shifts for non-empty circulant permutation matrices. This matrix usually has very low girth. Also a special parameter temperature is chosen associated with the simulated annealing approach with relatively high value.

In a second stage, the processor 101 is configured to iteratively improve the initial parity check matrix by repeating the procedure defined by the following pseudo code.

1. Nstep=0
2. Choose one random non-empty cell of the protograph.
3. Enumerate all possible cycles through this cell of length shorter than K.
4. Calculate number of existing cycles "ShiftCycles" for all possible shift values of this cell (using the techniques described above).
5. Take randomly one of these values with probability depending on the value of cycles and the temperature parameter of the annealing method. The probability weight function should be greater for smaller values of ShiftCycles(m), and the difference increases with a reduction of the temperature. One example of such probability weight function is

$$w(m) = e^{\frac{-ShiftCycles(m)}{Temperature}}$$

6. Exact probability of choice $m$ is $p(m) = w(m)/\sum_{i=0}^{N-1} w(i)$.
7. Decrease value of temperature. In each step, the temperature should monotonically decrease. One example of a formula for decreasing the temperature is

$$Temperature = Const \frac{Total\ number\ of\ cycles\ in\ protograph}{Nstep^2}$$

8. Increment Nstep and go to step 2.
9. Then if the result is stable for many iterations, finish the procedure.

A main feature of embodiments of the invention is the enumeration of the paths going through a given cell and for each cycle the number of cycles for each value of the shift of CPM for the given cell is determined. In an embodiment, this is done on the basis of a modified backtracking algorithm, as defined by the following pseudo code:

1. Define zero vector ShiftCycles of length N.
2. Enumerate all closed cycles with length shorter than given K, starting and ending in the given cell going through non-empty protograph cells, with vertical lines on even steps, and horizontal lines on odd steps.

3. Repeat the following procedure for each cycle:

4. Consider all horizontal edges (for every $1 \leq a < K$ $j_{a-1} = j_a$). Calculate the number of edges of the cycle which intersect the shifted zone of the protograph, and proceed to the left ($i_a \leq D(j_a), i_{a-1} > D(j_{a-1})$) and to the right ($i_a > D(j_a), i_{a-1} \leq D(j_{a-1})$). If the number of left intersections is not equal to the number of right intersections, it means that cycle is actually not-closed in the spatially-coupled matrix, and this cycle is discarded.

5. Calculate signed sum R of appearing shift $p_{i0,j0}$ of initial cell in equation (4)

6. Consider the starting cell to be a CPM with a shift $p_{i0,j0} = 0$ $I(0)$ (i.e. the circulant matrix with zero shift is the identity matrix) and calculate the total shift $S = \sum_{a=0}^{K-1} p_{i_a,j_a} - p_{i_a,j_{a+1}} \bmod N$ through this cycle.

7. The shift of the starting cell $p_{i0,j0}$ in S always goes with sign +, so for an arbitrary shift the equation can be written as: $R\,p_{i0,j0} + S = \bmod N$, and the forbidden values for $p_{i0,j0}$ can be found. For each solution $p_{i0,j0}$ increment the value of ShiftCycles($p_{i0,j0}$) (as described further above).

In an embodiment, the processor 101 is configured to solve the equation a x = b mod c occurring in step 7 of the above pseudo code in the following way:

1. Take $d = GCD(a,c)$

2. If $b\ mod\ d \neq 0$, there is no solution for $x$.

3. If $b\ mod\ d = 0$, take $a' = \dfrac{a}{d}, b' = \dfrac{b}{d}, c' = \dfrac{c}{d}$ and solve $a'\,x = b'\ (mod\ c')$.

4. If $a' = 0$ and $b = 0$, every x is a solution

5. If $a' = 0$ and $b \neq 0$, there is no solution.

6. If $a' \neq 0$ there is $e = a'^{-1}\ mod\ c'$, i.e. $a'\,e = 1\ mod\ c'$, then $x = b'\,e\ mod\ c'$

7. All solutions of the initial equation are $x_k = b'\,e\ mod\ c' + k\,c'$, for $0 \leq k < d$.

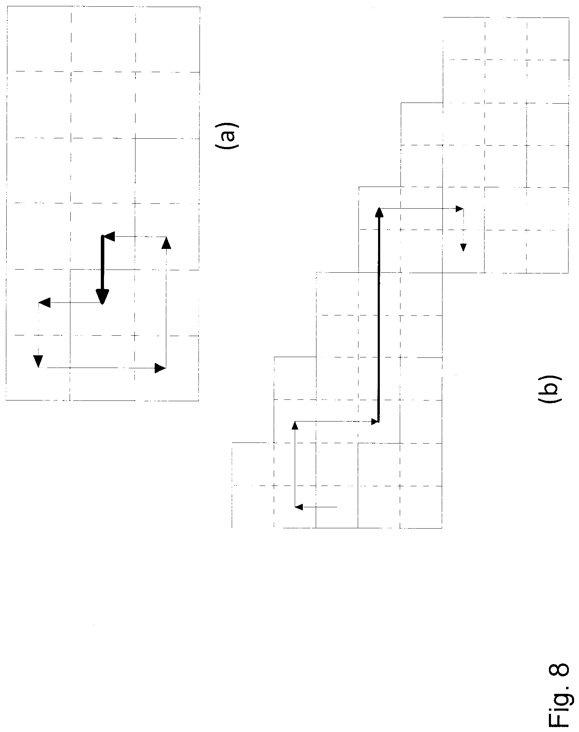

Figure 8a shows a schematic diagram illustrating a cycle in a protograph having a left edge intersecting shifted zone. Figure 8b shows a schematic diagram illustrating a cycle in a protograph having no closed cycle in the spatially coupled graph.

The following examples illustrate the performance of the base matrix lifting based on the simulated annealing (SA) algorithm described above in comparison to a conventional base matrix lifting based on a hill-climbing (HC) algorithm.

In a first example, the value of the circulant for a regular protograph with row number 3 and column number L with girth 8 (less value better) can be taken from the following table for the two different algorithms mentioned above.

|  | L=4 | L=5 | L=6 | L=7 | L=8 | L=9 | L=10 | L=11 | L=12 |
|---|---|---|---|---|---|---|---|---|---|
| SA | 9 | 13 | 18 | 21 | 25 | 30 | 35 | 40 | 45 |
| HC | 9 | 13 | 18 | 21 | 25 | 30 | 35 | 41 | 47 |

In a second example, the value of the circulant for a regular protograph with row number 3 and column number L with girth 10 (less value better) can be taken from the following table for the two different algorithms mentioned above.

|  | L=4 | L=5 | L=6 | L=7 | L=8 | L=9 | L=10 | L=11 | L=12 |
|---|---|---|---|---|---|---|---|---|---|
| SA | 39 | 63 | 97 | 144 | 215 | 297 | 409 | 542 | 698 |
| HC | 39 | 63 | 103 | 160 | 233 | 329 | 439 | 577 | 758 |

As can be taken from these tables, in both examples the SA algorithm outperforms the HC algorithm, i.e. provides smaller circulant values, for different numbers of columns.

The processing block 617 shown in figure 6b is based on the following considerations.

Let H be a parity check matrix based on a regular (j,k)-code $C(H)$ with length n (with $n = WN$) and let the corresponding Tanner graph have one component. Let $L \triangleq H^T H$ and let $\mu_1, \mu_2$ be the largest and the second-largest eigenvalue, respectively, of L. It has been shown that in this case the minimum Hamming weight and the minimum AWGNC pseudo-weight have the following lower bounds:

$$w_H^{min}(C(H)) \geq w_p^{min} \geq n \cdot \frac{2j - \mu_2}{\mu_1 - \mu_2}.$$

This result can be applied not only to regular codes, but to non-regular codes as well in the following way:

$$w_H^{min}(C(H)) \geq w_p^{min} \geq n \cdot \frac{2j_{avg} - \mu_2}{\mu_1 - \mu_2},$$

where $j_{avg}$ is the average weight of the code $C(H)$.

On the basis of the above relations the processor 101 is configured to discard codes having a small lower bound for the pseudo code weights.

In a block 619 of figure 6b the processor 101 is configured to perform the same selection as described in the context of block 611 of figure 6a.

In a processing block 621 of figure 6b the processor 101 is configured to perform a further selection step on the basis of a tighter upper bound for the minimum Hamming distance of the respective candidate parity check matrices on the basis of information about the CPM shifts.

Generally, the minimum Hamming distance is an important characteristic of a given parity check matrix. It provides an estimate for the level of undetectable errors as well as an upper bound on the minimum pseudo-weight of a Tanner graph representing a code.

If the size of the circulant of a spatially coupled code approaches infinity, the spatially coupled code becomes a convolution code. Consequently, a convolution code provides a good approximation for a spatially coupled code. As already mentioned above, [**W**] denotes the set of numbers from [0... $W$ - 1]. It has been shown that for a QC code $C(H)$ with a circulant parity check matrix H an upper bound for the minimum Hamming distance of the code is the following:

$$d_{min}(C(H)) \leq \min_{\substack{S \subseteq \subseteq [\mathbf{W}] \\ |S| = C+1}}^{+} \sum_{i \in S} wt\left(perm\left(H_{S \setminus i}(x)\right)\right) \quad (6)$$

In an embodiment, the processor 101 is configured to estimate a tighter upper bound for the minimum Hamming distance on the basis of equation (6). In an embodiment, the processor 101 is configured to keep a code, if the tighter upper bound of the Hamming distance provided by equation (6) is substantially equal to the upper bound provided by equation (5) (which, in turn, implies that the upper bounds are substantially equal to $(C + 1)!$).

The use of equation (6), as implemented in embodiments of the invention, will be illustrated in the following on the basis of the two examples already mentioned above, i.e. for a first code $C(H_1)$ with parity check matrix

$$H_1(x) = \begin{pmatrix} x & x^2 & x^4 & x^8 \\ x^5 & x^6 & x^3 & x^7 \end{pmatrix},$$

and a second code $C(H_2)$ with parity check matrix

$$H_2(x) = \begin{pmatrix} x & x^2 & x^4 & x^8 \\ x^6 & x^5 & x^3 & x^9 \end{pmatrix}.$$

As described above, equation (5) provides for both of these codes the same upper bound having the value 6.

Using equation (6) one obtains for the first code:

$$d_{min}(C(H_1)) \leq min^+ \begin{Bmatrix} wt(x^4 + x^9) + wt(x^5 + x^{10}) + wt(x^7 + x^7) \\ wt(x^9 + x^{14}) + wt(x^8 + x^{13}) + wt(x^7 + x^7) \\ wt(x^{11} + x^{11}) + wt(x^8 + x^{13}) + wt(x^4 + x^9) \\ wt(x^{11} + x^{11}) + wt(x^9 + x^{14}) + wt(x^5 + x^{10}) \end{Bmatrix}$$

$$= min^+\{4,4,4,4\} = 4$$

Using equation (6) one obtains for the second code:

$$d_{min}(C(H_2)) \leq min^+ \begin{Bmatrix} wt(x^5 + x^9) + wt(x^4 + x^{10}) + wt(x^6 + x^8) \\ wt(x^{11} + x^{13}) + wt(x^{10} + x^{14}) + wt(x^6 + x^8) \\ wt(x^{13} + x^{11}) + wt(x^{10} + x^{14}) + wt(x^4 + x^{10}) \\ wt(x^{13} + x^{11}) + wt(x^{11} + x^{13}) + wt(x^5 + x^9) \end{Bmatrix}$$

$$= min^+\{6,6,6,6\} = 6$$

Thus, the additional check performed by the processor 101 in block 621 of figure 6b would show that for the two examples above the first code is better than the second code and that, consequently, the second code would be discarded.

In a processing block 623 of figure 6b the processor 101 is configured to perform the same selection as described in the context of block 611 of figure 6a.

In a processing block 625 of figure 6b the processor 101 is configured to perform an exact calculation of the minimum Hamming distance for the remaining code candidates. In an embodiment, the processor 101 is configured to perform this exact calculation on the basis of an algorithm for finding the minimal distance in a lattice, as will be described in more detail in the following. In other words, in an embodiment the processor 101 is configured to determine real code distances using number theory.

The rows of a parity check matrix H can be considered as vectors $b_i$. Let

$$L(b_0, b_1, ..., b_{n-1}) = \left\{\sum_{i=0}^{n-1} x_i b_i : (x_0, x_1, ..., x_{n-1}) \in Z^n\right\}$$ be a lattice over the vectors $b_i$ (n=CL-1). The processor 101 is configured to determine the minimum distance between vertices of this lattice and to determine minimum Hamming distance for H on the basis thereof.

In an embodiment, the processor 101 is configured to generate a lattice based on a code C(H) such that the minimal non-zero lattice vector corresponds to the minimal Hamming distance vector in the code.

In a first stage, the processor 101 is configured to choose a scaling factor N with

$$N \geq \left\lceil \gamma_\beta^{\frac{n-1}{\beta-1}} 2\sqrt{(m+1)(n+1)} r_{max} M^m \right\rceil,$$

where $\gamma_\beta$ denotes the Hermite constant, $\beta$ denotes the maximal degree of block Korkin-Zolotarev method reduction that we will be described in more detail further below, $r_{max}$ denotes the determined good upper bound for the minimal distance of the lattice based on previous steps of this algorithm with smaller $\beta$, and $M = max(\|A_0\|, \|A_1\|, ..., \|A_{n-1}\|, \|d\|)$.

In a second stage, the processor 101 is configured to construct the lattice A $(B_c)$ on the basis of the matrix

$$B_c = \begin{pmatrix} N \cdot H' & N \cdot qE_{n-k} \\ E_k & 0 \end{pmatrix},$$

wherein $H'$ denotes the generator matrix for the code $C(H)$ and $E_k$ denotes the identity matrix of size $k$. If one encoded vector $H' c_1$ has more ones than another encoded vector $H' c_2$, i.e. $\|H' c_1\|_1 < \|H' c_2\|_1$, then the following relation holds for the Euclidian distance: $\|B_c c_1\|_2 < \|B_c c_2\|_2$ (for N being large enough). For this reason, it is possible for the processor 101 to find the minimal distance vector $v \in \{A (B_c)\backslash\emptyset\}$ with $\|v\|_\infty = 1$, which, in turn, provides the minimum Hamming distance of the code $C(H)$.

In an embodiment, the processor 101 is configured to use a Gram-Schmidt orthogonalization process. In an embodiment, the processor 101 is configured to generate an orthogonal basis using the following equations:

$$b_0^\perp = b_0,$$

$$b_1^\perp = b_1 - \mu_{0,1}\, b_0,$$

...

$$b_{n-1}^\perp = b_{n-1} - \sum_{i=0}^{n-2} \mu_{i,n-1}\, b_0,$$

where $\mu_{i,j} = \dfrac{\langle b_i, b_j\rangle}{\langle b_j, b_j\rangle}$ .

Ordered by length basis $B = \{b_0, b_1, ..., b_{n-1}\}$ of lattice $L \subset \mathbb{R}^m$ is adducted by block Korkin-Zolotarev method with block size $\beta \in [2, m]$ and precision $\delta \in \left(\frac{1}{2}; 1\right]$ , if:

- Basis B adducted by length ($|b_i| \le |b_j|$ iff $i > j$)
- $\delta^2 \cdot \left\| b_i^\perp \right\|^2 \le \lambda_1^2(L_i)$ , $i \in \{0, ..., m-1\}$, where $\lambda_1(L_i)$ - length of shortest vector in the lattice $L_i$, in the orthogonal space with basis $b_i, ..., b_{\min(i+\beta-1, m-1)}$.

On the basis of the definitions above, the algorithm implemented in the processor 101 for constructing a basis adducted by block Korkin-Zolotarev method can be defined by the following pseudo code:

Input: $B = \{b_0, b_1, ..., b_{n-1}\} \in [0,1]^n$, $\delta \in \left(\frac{1}{2}; 1\right]$ , $\beta \in [2, m]$

1. Start same algorithm with lower values of $\beta$.
2. Z:=0; j:=0
3. WHILE z<m-1 DO

    a. j:=j+1; k:=min(j+ $\beta$ - 1,$m$)
    b. IF j=m THEM j:=0; k:= $\beta$
    c. $A=|b_j|$
    d. $b_j^{new} = \text{find\_minimal\_vector}(k, \{b_j, b_{j+1}, ..., b_{j+k-1}\}, A)$
    e. h:=min(k+1,m)
    f. IF $\delta\, |b_j| > |b_j^{new}|$ THEN $b_j := b_j^{new}$ ; $z := 0$ ELSE z:=z+1

Output: B

In an embodiment, the processor 101 is configured determine for given k, B, A the shortest vector of the lattice $L_{i,k} = \sum_{i=0}^{k-1} x_i b_{i+j} : (x_0, x_1, ..., x_{k-1}) \in Z^k\}$ spanned over the vectors $b_j$. In an embodiment, the corresponding algorithm implemented in the processor 101 can work in a parallel mode with several nodes up to A (upper bound for minimal distance). The algorithm, which according to an embodiment is implemented in the processor 101 and is defined by the following pseudo code, is basically an n-fold cycle with calculated start and end for each cycle and a reduction of the upper bound A for each recorded distance.

Input: $j, k, B = \{b_0, b_1, ..., b_{k-1}\} \in [0,1]^k$, id - id of the node.

1. Calculate $B^\perp = \{b_0^\perp, b_1^\perp, ... b_{k-1}^\perp\}$ and matrix $\mu_{i,j}$
2. X={id,0,0,...0}; $l = \{0\}^m$, $R = \{\varnothing\}$;
3. i:=0

4. WHILE $i \leq k$:

a. $l_i = (x_i + \sum_{j=i+1}^{m} x_j \, \mu_{j,i})^2 \, \left\| b_i^{\perp} \right\|^2$

b. IF $\left( \sum_{j=i+1}^{k-1} l_j > A \right)$ THEN i:=i+1; $x_i = x_i + 1$

c. IF $\left( \sum_{j=i+1}^{k-1} l_j \leq A \right)$ AND i=0 THEN

    i. IF $\left\| \sum_{j=0}^{k-1} x_j b_j \right\| < A$ THEN $A = \left\| \sum_{j=0}^{k-1} x_j b_j \right\|, R = R \cup \left\{ \sum_{j=0}^{k-1} x_j b_j \right\}$

d. IF $\left( \sum_{j=i+1}^{k-1} l_j \leq A \right)$ AND i>0 THEN

    i. i:=i-1,

    ii.
$$x_i = \left\lceil -\sum_{j=i+1}^{m} x_j \mu_{j,i} - \frac{\sqrt{A - \sum_{j=i+1}^{m} l_j}}{\left\| b_i^{\perp} \right\|^2} \right\rceil$$

5. Return element from R with smallest norm.

In a processing block 627 of figure 6b the processor 101 is configured to determine one or more stopping sets on the basis of the following algorithm. A stopping set of size s is a subset $\tilde{V} = \{v_{i0}, v_{i1}, ..., v_{i_{s-1}}\}$ of the variables nodes such that the induced subgraph $T(\tilde{V})$ has no check nodes of degree one. A constraint set F, is a set $\{(p_i, s_{p_i}): s_{p_i} \in \{0,1\} \, \forall \, p_i \in \Gamma\}$, where $\Gamma \subseteq \{0,...,n-1\}$ ($n = WN$) is a set of distinct codeword positions. Let $\chi(F) = \{p_i: (p_i, 1) \in F\}$, i.e. the support set of the constraint set $F$. $H_A$ denotes the parity-check matrix consisting of columns from H corresponding to indices from the set $A \subseteq \{0, ..., n-1\}$, and with the all-zero columns with indices from $\Gamma \setminus A$. The row of the parity-check matrix is active, if the row weight is exactly one. The set of indices of active rows in H is $\phi(H)$. The support set $\chi(x)$ of vector $x \in \{0,1\}^n$ is the set of indices of non-zero elements of $x$, where there are no active rows, i.e. $|\phi(H)| = 0$. $S \subseteq \{0,1\}^n$ denotes the set of all length-n binary vectors and $S^{(F)} = (s_0, ..., s_{n-1}) \in S: s_j = s$ if $(j, s) \in F$. $S_H$ denotes the unique maximum subset of $\{0,1\}^n$ such that for every element $s \in S_H$, with support set $\chi(s)$. The constraint set F is valid if and only if $S_H^F = (S_H)^F$ is non-empty. The weight function w(F) is the Hamming weight of $(S_H)^F$ when F is valid and infinity is F is not valid (which is a way to obtain trapping sets subgraph). $W'(F)$ is any lower bound of $W(f)$.

In an embodiment, the processor 101 is configured to determine one or more stopping sets on the basis of a branch-and-bound method. There are $2^{WL}$ possible values of a coding vector of length WL. In an embodiment, this set of all possible values is split into branches by adding constraints of the kind $x_i = k$. In an embodiment, the processor 101 is configured to determine all stopping sets of length $\tau$ or less on the basis of a branch-and-bound method, as defined by the following pseudo code:

1. Generate initial list of constraints sets L from one element - empty constraint set F={}.
2. Split constraint set. Take first constraint F from list L. Most general and simple constraint set F={}. Every constraint set F can be split into two, by any variable $x_i$, $F_2 = F \cup \{x_i = 0\}$ and $F_2 = F \cup \{x_i = 1\}$. Replace constraint set F in the list L into two new constraints sets $F_1$ and $F_2$.
3. Repeat the following steps 4 to 6 for each constraints set $F_1$ and $F_2$
4. Extend constraints set. Perform extended iterative decoding with achieve some values of $x_i \notin F_k$. Add these values as additional constraints to $F_k$. In case the extension of the constraints set leads to contradictory results, the constraint set can be eliminated.
5. Find new stopping sets. If constraint $F_k$ has all fixed variables, i.e. corresponds to a single point, check whether it has number of 1 equal or less than $\tau$, add $\chi(F_k)$ to list of the stopping sets already found.
6. Bound part, eliminate branch. Calculate lower bound $w'(F)$ of minimal stopping set. If $w'(F) > \tau$, eliminate $F_k$.
7. If L is not empty return to step 2.

In an embodiment, the processor 101 is configured to determine a lower bound of the minimal stopping set for the constraint set F in the following way. Let q denote the number of constraints $x_i = 1$ in the constraint set F. Let T(F) denote the set of columns, whose indices are not empty and are not used in the constraint set $F$. Let $\tilde{H}$ denote a submatrix of $H$ consisting of columns from the set $T(F)$. It has been shown that the following linear lower estimation holds:

$$w'(F) = q + \min_{x_i \geq 0} \sum_{i=0}^{|T(F)|-1} x_i,$$

when $\tilde{H}x \geq (1, ..., 1)^T$

In an embodiment, the processor 101 is configured to compute the above lower bound using linear optimisation.

In a processing block 629 of figure 6b the processor 101 is configured to estimate a pseudo code weight of a trapping set in the following way. To enumerate trapping sets an approach simulating a belief propagation algorithm with deterministic noise of specific tree-like shapes can be used by the processor 101. It is assumed that the girth of the graph is larger than 4. Consider some variable "root" node in the Tanner graph as well as three variable nodes at a distance of 2 from this root node. A minimal tree containing these 4 variable nodes is a 4VN subgraph. These 4VN subgraphs satisfy the following two important properties:

- Each trapping intersects by 3 variable vertices with at least one such 4VN subgraph. Three variable vertices are in the cycle and one variable node is connected to the cycle via a check node.
- The number of 4VN subgraphs is relatively small and possible to enumerate. The number of these variants is bounded by $n (d_c - 1)^{d_v}$, where n=WN denotes the number of variables, $d_v$ denotes the weight of the column (for irregular codes maximal weight of the column), and $d_c$ denotes the weight of the row.

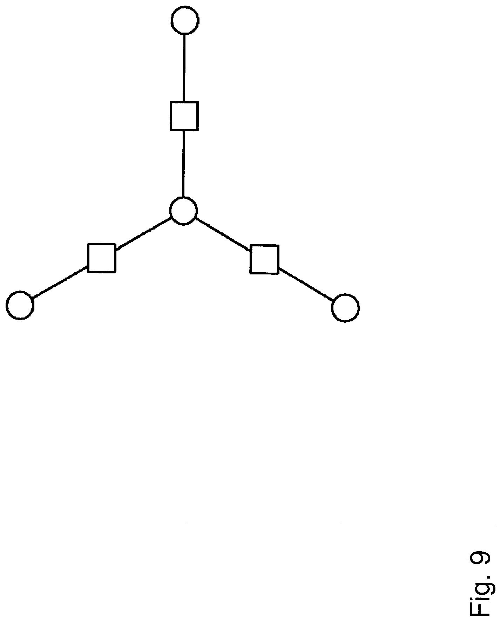

Figure 9 shows a schematic diagram illustrating an exemplary 4VN subgraph of a protograph.

Using a 4VN subgraph specific noise can be constructed for belief propagation algorithm (Sum-product). As the code is linear, without loss of generality it can be assumed that the sent data is all-zeros and decoded '1' corresponds to mistakes, positive LLR corresponds to '1' and negative to '0'.

The noise measured in LLR is constructed by putting $k(1-\varepsilon_1)$ into 4 variable nodes for a given 4VN subgraph, and for all other variable nodes $k\gamma$ is chosen, where k is the cannel factor, and $\varepsilon_1, \gamma$ denote manually chosen parameters.

Constants are chosen to obtain the situation that an error causes only a small number of unsatisfied parity checks. The channel factor k has the same meaning as in the normal decoding process, i.e. it is a factor used to convert received signal to the log-likelihood values. More precisely, for an AWGN channel with variance $\sigma^2$, the channel factor is $\dfrac{2}{\sigma^2}$ .

The constant $\gamma$ can be chosen to be less than 1 to "weaken" the graph not affected by an error impulse. Preferred values for $\gamma$ range from 0.3 to 0.8 depending on a graph. The error magnitude $\varepsilon$ can be chosen empirically large enough to provoke errors in the trapping sets.

For each described above error impulse the processor 101 is configured to start the decoding process. Denote by $x_i$ the hard decision after i iterations (it is assumed that the processor 101 performs at most $i_{max}$ iterations). Find the number of steps, when the number of unsatisfied parity checks is minimal: $i^* = \underset{1 \leq i \leq i_{max}}{\operatorname{argmin}} w_H(Hx_i)$ . Let $S(x)$ be a set of variable nodes whose corresponding bits in the vector x are 1.

Then a subgraph included by $S(X_{i*})$ is considered as a trapping set. If $S(x_{i*})$ is not a trapping set, the processor 101 tries growing each $S(x_i)$, $\dfrac{k_{max}}{2} \leq i \leq k_{max}$ into a trapping set. To this end, the processor 101 is configured to determine a minimal set $S'(x_i) \supset S(x_i)$ which contains at least one cycle. Thereafter, the processor 101 is configured to find a minimal set $S''(x_i) \subset S'(x_i)$, which contains the same cycles as the set $S'$ (in other words, does not contain any tree like structures). The processor 101 provides $S''(x_i)$ as the trapping set for $x_i$.

In an embodiment, the apparatus 100 can maintain a list of all trapping sets found, in particular of the recently determined trapping sets. In an embodiment, this list of trapping sets is maintained by the apparatus in a lexicographic order, i.e. $T' < T''$ iff $T_1' < T_1''$ or $T_1' = T_1''$ and $T_2' < T_2''$. In an embodiment, the apparatus 100 is configured to delete the last trapping set on the list, if the list of trapping sets becomes too large.

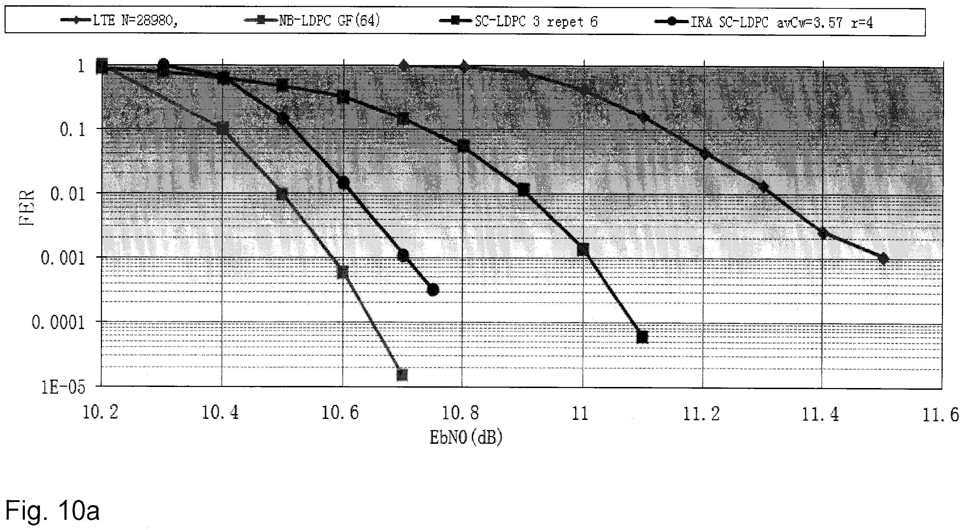

Figure 10a shows a diagram illustrating the performance of codes provided by embodiments of the invention in comparison with conventional codes. More specifically, figure 10a shows a comparison of the performance of N=28980, R=0.879 LTE with 8 iteration max-log-map, two families of binary SC-LDPC codes which use a base matrix: regular code with column weight 3, circulant 230 and irregular RA with average column weight 3.57 and circulant 57 under 30 iterations of layered min-sum and NB GF(64) QC-LDPC based on expander graph under 30 iteration QSPA-FFT, QAM-64.

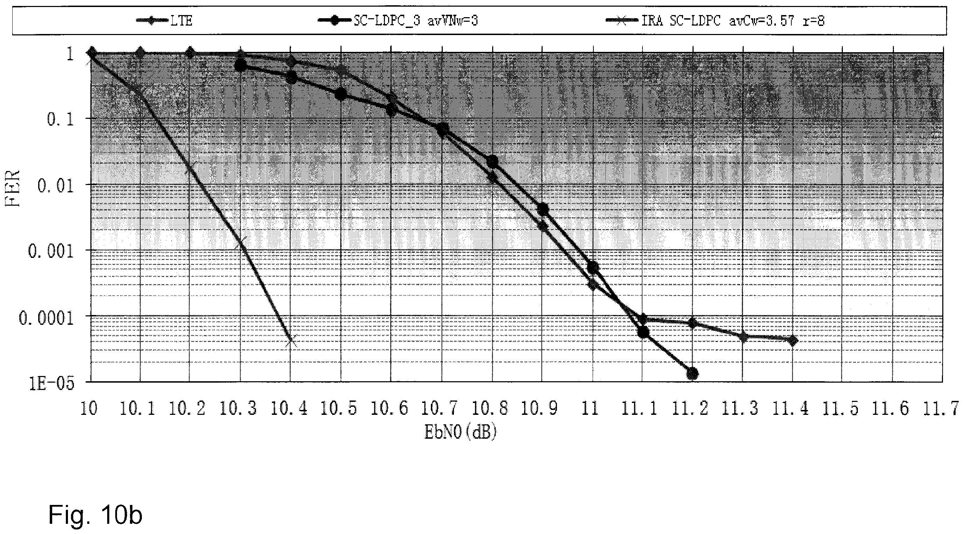

Figure 10b shows a diagram illustrating the performance of codes provided by embodiments of the invention in comparison with conventional codes. More specifically, shows a comparison of the performance of N=44160, R=0.6 LTE with 8 iteration max-log-map, two binary SC-LDPC codes which use base matrix: regular code with column weight 3, circulant 320 and irregular RA with average column weight 3.57 circulant 138 under 30 iterations of layered min-sum, QAM 256.

As can be taken from figures 10a and 10b, tail-biting SC-LDPC codes provided by embodiments of the invention show good performance in the "waterfall"" region, have a hardware friendly decoder (every repetition uses the same code, moreover a window decoder can be used to get more convolutional gain with constant latency) and an encoder of reasonable complexity using CPM Gaussian elimination approach, as provided by embodiments of the invention.

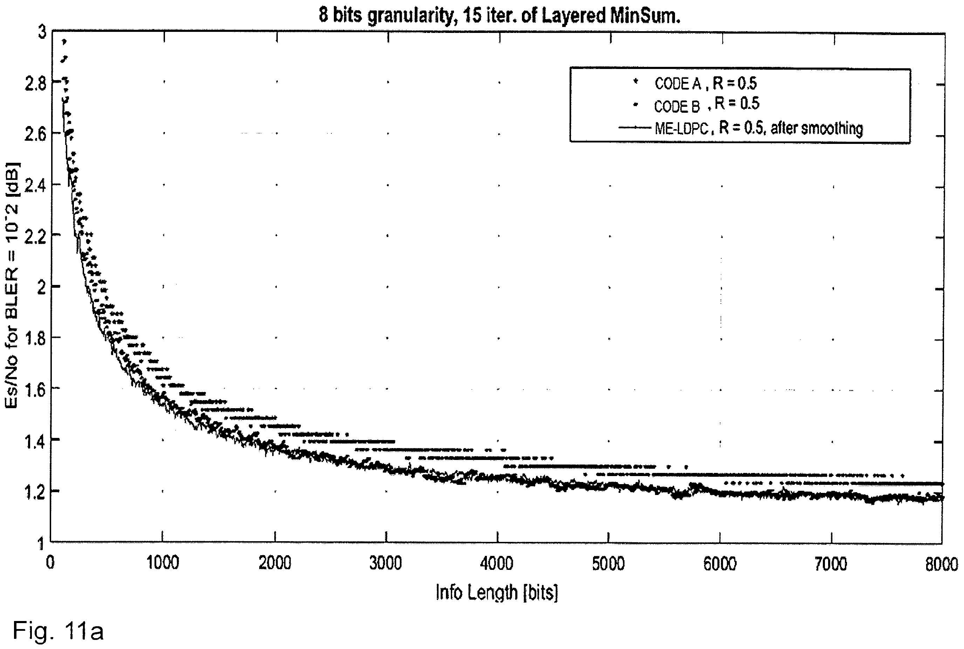

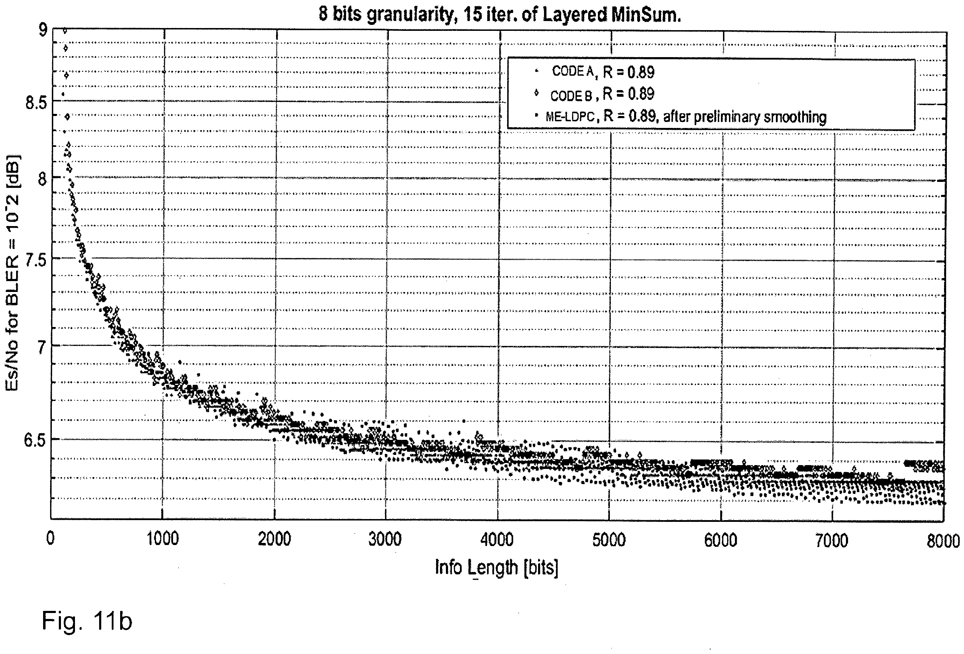

Figure 11a, 11b shows a diagram illustrating the performance of Multi-edge LDPC codes provided by embodiments of the invention in comparison with known codes from recent 3gpp proposals, namely Codes A and Codes B. More specifically is shows a comparison of the SNR required for codes with rates 1/2 and 0.89 for an information length in the range from K=100 to 8000 to reach a Frame Error Rate $10^{-2}$ under 15 iteration of layered normalized min-sum, QPSK.

Embodiments of the invention provide on the basis of a QC-LDPC protograph a block version of a convolutional code, namely a tail-biting spatially-coupled (SC) LDPC code. Embodiments of the invention allow generating a code with SC-LDPC structures of the graph using a Belief Propagation with the following properties: large Hamming distance (code properties), better structures of cycles (graph properties - ACE Spectrum when ACE=EMD) and reasonable complexity (average column weight, size of base matrix, maximal column weight).

While a particular feature or aspect of the disclosure may have been disclosed with respect to only one of several implementations or embodiments, such feature or aspect may be combined with one or more other features or aspects of the other implementations or embodiments as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims and their equivalents, the invention may be practiced otherwise than as specifically described herein.

**Claims**

1. An apparatus (100) for wireless communication and configured for providing a parity check matrix defining a tail-biting spatially-coupled quasi-cyclic low density parity check, QC-LDPC, code on the basis of a set of base matrix parameters defining a plurality of base matrices, each base matrix of the plurality of base matrices being associated with a protograph of a plurality of protographs, wherein the set of base matrix parameters defines the size WxC, a circulant size N, a maximal column weight M and a set of allowed column weights of the plurality of base matrices, wherein the apparatus (100) comprises:

   a processor (101) configured to:

   generate on the basis of a plurality of protographs a set of candidate protographs by discarding protographs of the plurality of protographs;
   lift the protographs of the set of candidate protographs for generating a plurality of codes;
   generate on the basis of a plurality of codes a set of candidate codes by discarding codes of the plurality of codes, and
   facilitating wireless communication based on the set of candidate codes, **characterized in that** the processor (101) is configured to lift the protographs of the set of candidate protographs on the basis of a simulated annealing technique.

2. The apparatus (100) of claim 1, wherein the processor (101) is further configured to discard protographs of the plurality of protographs on the basis of the balanced girth of the parity check matrix H associated with each protograph.

3. The apparatus (100) of any one of the preceding claims, wherein the processor is further configured to discard those protographs of the plurality of protographs that are associated with an extrinsic message degree (EMD) that is smaller than an EMD threshold value.

4. A method for wireless communication and for providing a parity check matrix defining a tail-biting spatially-coupled quasi-cyclic low density parity check, LDPC, code on the basis of a set of base matrix parameters defining a plurality of base matrices, each base matrix of the plurality of base matrices being associated with a protograph of a plurality of protographs, wherein the set of base matrix parameters defines the size WxC, a circulant size N, a maximal column weight M and a set of allowed column weights of the plurality of base matrices, wherein the method comprises using a processor (101) for:

generating on the basis of the plurality of protographs a set of candidate protographs by discarding protographs of the plurality of protographs;
lifting the protographs of the set of candidate protographs for generating a plurality of codes;
generating on the basis of the plurality of codes a set of candidate codes by discarding codes of the plurality of codes, and
facilitating wireless communication based on the set of candidate codes,
**characterized in that** the step of lifting the protographs of the set of candidate protographs is based on a simulated annealing technique.

5. The method of claim 4, wherein the method is further configured to discard protographs of the plurality of protographs on the basis of the balanced girth of the parity check matrix H associated with each protograph.

6. The method of any one of the preceding claims 4 and 5, wherein the method is further configured to discard those protographs of the plurality of protographs that are associated with an extrinsic message degree (EMD) that is smaller than an EMD threshold value.

**Patentansprüche**

1. Einrichtung (100) für eine drahtlose Kommunikation und die zum Bereitstellen einer Paritätsprüfungsmatrix konfiguriert ist, die einen tail-biting, räumlich gekoppelten, quasi-cyclischen Code für Paritätsprüfungen niedriger Dichte (quasi-cyclic low density parity check - QC-LDPC) basierend auf einem Satz von Basismatrixparametern definiert, der mehrere Basismatrizen definiert, wobei jede Basismatrix der mehreren Basismatrizen mit einem Protographen von mehreren Protographen verknüpft ist, wobei der Satz von Basismatrixparametern die Größe WxC, eine Zirkulantengröße N, ein maximales Spaltengewicht M und einen Satz von möglichen Spaltengewichten der mehreren Basismatrizen definiert, wobei die Einrichtung (100) Folgendes umfasst:
einen Prozessor (101), der für Folgendes konfiguriert ist:

Erzeugen, basierend auf den mehreren Protographen, eines Satzes von Kandidatenprotographen durch Verwerfen von Protographen der mehreren Protographen;
Anheben der Protographen des Satzes von Kandidatenprotographen zum Erzeugen mehrerer Codes;
Erzeugen, basierend auf mehreren Codes, eines Satzes von Kandidatencodes durch Verwerfen von Codes der mehreren Codes und Ermöglichen von drahtloser Kommunikation basierend auf dem Satz von Kandidatencodes,
**dadurch gekennzeichnet, dass** der Prozessor (101) konfiguriert ist, um die Protographen des Satzes von Kandidatenprotographen basierend auf einer simulierten Glühtechnik anzuheben.

2. Einrichtung (100) nach Anspruch 1, wobei der Prozessor (101) ferner konfiguriert ist, um Protographen der mehreren Protographen basierend auf dem ausgeglichenen Umfang der Paritätsprüfungsmatrix H, die mit jedem Protographen verknüpft ist, zu verwerfen.

3. Einrichtung (100) nach einem der vorhergehenden Ansprüche, wobei der Prozessor ferner konfiguriert ist, um diejenigen Protographen der mehreren Protographen, die mit einem Grad einer extrinsischen Nachricht (extrinsic message degree - EMD) verknüpft sind, der kleiner als ein EMD-Schwellenwert ist, zu verwerfen.

4. Verfahren für die drahtlose Kommunikation und zum Bereitstellen einer Paritätsprüfungsmatrix, die einen tail-biting, räumlich gekoppelten, quasi-cyclischen Code für Paritätsprüfungen niedriger Dichte (LDPC) basierend auf einem Satz von Basismatrixparametern definiert, der mehrere Basismatrizen definiert, wobei jede Basismatrix der mehreren Basismatrizen mit einem Protographen von mehreren Protographen verknüpft ist, wobei der Satz von Basismatrixparametern die Größe WxC, eine Zirkulantengröße N, ein maximales Spaltengewicht M und einen Satz von möglichen Spaltengewichten der mehreren Basismatrizen definiert, wobei das Verfahren ein Verwenden eines Prozessors (101) für Folgendes umfasst:

Erzeugen, basierend auf den mehreren Protographen, eines Satzes von Kandidatenprotographen durch Verwerfen von Protographen der mehreren Protographen;
Anheben der Protographen des Satzes von Kandidatenprotographen zum Erzeugen mehrerer Codes;
Erzeugen, basierend auf den mehreren Codes, eines Satzes von Kandidatencodes durch Verwerfen von Codes der mehreren Codes und Ermöglichen von drahtloser Kommunikation basierend auf dem Satz von Kandidatencodes,
**dadurch gekennzeichnet, dass** der Schritt des Anhebens der Protographen des Satzes von Kandidatenprotographen auf einer simulierten Glühtechnik basiert.

5. Verfahren nach Anspruch 4, wobei das Verfahren ferner konfiguriert ist, um Protographen der mehreren Protographen basierend auf dem ausgeglichenen Umfang der Paritätsprüfungsmatrix H, die mit jedem Protographen verknüpft ist, zu verwerfen.

6. Verfahren nach einem der vorhergehenden Ansprüche 4 und 5, wobei das Verfahren ferner konfiguriert ist, um diejenigen Protographen der mehreren Protographen, die mit einem Grad einer extrinsischen Nachricht (EMD) verknüpft sind, der kleiner als ein EMD-Schwellenwert ist, zu verwerfen.

## Revendications

1. Appareil (100) de communication sans fil et configuré pour fournir une matrice de contrôle de parité définissant un code de contrôle de parité quasi-cyclique à faible densité, QC-LDPC, couplé spatialement et à fermeture circulaire de treillis, sur la base d'un ensemble de paramètres de matrice de base définissant une pluralité de matrices de base, chaque matrice de base parmi la pluralité de matrices de base étant associée à un protographe parmi une pluralité de protographes, l'ensemble de paramètres de matrice de base définissant la taille WxC, une taille circulante N, un poids de colonne maximal M et un ensemble de poids de colonne autorisés de la pluralité de matrices de base, l'appareil (100) comprenant :
un processeur (101) configuré pour :

générer sur la base d'une pluralité de protographes un ensemble de protographes candidats en rejetant les protographes de la pluralité de protographes ;
développer les protographes de l'ensemble de protographes candidats pour générer une pluralité de codes ;
générer sur la base d'une pluralité de codes un ensemble de codes candidats en rejetant les codes de la pluralité de codes, et en facilitant la communication sans fil sur la base de l'ensemble de codes candidats,
**caractérisé en ce que** le processeur (101) est configuré pour développer les protographes de l'ensemble de protographes candidats sur la base d'une technique de recuit simulé.

2. Appareil (100) selon la revendication 1, le processeur (101) étant en outre configuré pour rejeter les protographes de la pluralité de protographes sur la base de la circonférence équilibrée de la matrice de contrôle de parité H associée à chaque protographe.

3. Appareil (100) selon l'une quelconque des revendications précédentes, le processeur étant en outre configuré pour rejeter les protographes de la pluralité de protographes qui sont associés à un degré de message extrinsèque (EMD) qui est inférieur à une valeur seuil d'EMD.

4. Procédé de communication sans fil et destiné à fournir une matrice de contrôle de parité définissant un code de contrôle de parité quasi-cyclique à faible densité, LDPC, à fermeture circulaire de treillis et couplé spatialement sur la base d'un ensemble de paramètres de matrice de base définissant une pluralité de matrices de base, chaque matrice de base parmi la pluralité de matrices de base étant associée à un protographe parmi une pluralité de protographes, l'ensemble de paramètres de matrice de base définissant la taille WxC, une taille circulante N, un poids de colonne maximal M et un ensemble de poids de colonne autorisés de la pluralité de matrices de base, le procédé comprenant l'utilisation d'un processeur (101) pour :

générer sur la base de la pluralité de protographes un ensemble de protographes candidats en rejetant les protographes de la pluralité de protographes ;
développer les protographes de l'ensemble de protographes candidats pour générer une pluralité de codes ;
générer sur la base de la pluralité de codes un ensemble de codes candidats en rejetant les codes de la pluralité de codes, et en facilitant la communication sans fil sur la base de l'ensemble de codes candidats, **caractérisé en ce que** l'étape de développement des protographes de l'ensemble de protographes candidats est basée sur une technique de recuit simulé.

5. Procédé selon la revendication 4, le procédé étant en outre configuré pour rejeter les protographes de la pluralité de protographes sur la base de la circonférence équilibrée de la matrice de contrôle de parité H associée à chaque protographe.

6. Procédé selon l'une quelconque des revendications 4 et 5 précédentes, le procédé étant en outre configuré pour rejeter les protographes de la pluralité de protographes qui sont associés à un degré de message extrinsèque (EMD) qui est inférieur à une valeur seuil d'EMD.

Fig. 1

Fig. 2

Fig. 3

Fig. 4

Fig. 5

603

Full enumeration of protographs

601 — WxC is small enough?

yes

no

602 — Generation of good columns and row weights with good EXIT chart

605

$d_{min} < d_{free}$

607

Balanced cycle

609 — Protograph has parallel edges?

no

611

ACE=EMD

613

$d_{min} < d_{free}$

yes

Intermediate protograph lifting

610

604 — Generation sets of protograph with given weights

606 — Simulate protograph

615

Base matrix lifting by simulated annealing

Fig. 6a

615 — Base matrix lifting by simulated annealing

617 — Tanner spectral bound

619 — ACE=EMD

621 — Tight upper bound for $d_{min}$

623 — ACE=EMD

625 — Finding exact minimal distance

Hamming weight of stopping set

627 —

Pseudo code weight of Trapping Set using Cole methods

629 —

Fig. 6b

Fig. 7

Fig. 8

Fig. 9

Fig. 10a

Fig. 10b

EP 3 533 145 B1

Fig. 11a

Fig. 11b

EP 3 533 145 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20150155884 A1
- US 8103931 B2
- US 2016233979 A1
- WO 2013047258 A1

### Non-patent literature cited in the description

- **R. M. TANNER ; D. SRIDHARA ; A. SRIDHARAN ; T. E. FUJA ; D. J. COSTELLO.** LDPC block and convolutional codes based on circulant matrices. *IEEE Transactions on Information Theory,* December 2004, vol. 50 (12), 2966-2984
- **YIGE WANG et al.** Hierarchical and High-Grith QC LDPC codes. *IEEE Transactions on Information Theory,* 01 July 2013, vol. 59 (7), 4553-4583
- Novel types of cyclically-coupled quasi-cyclic LDPC block codes. **LAU, FRANCIS C. M et al.** Proc. IEEE International Conference on Advanced Technologies for Communication. ATC, 12 October 2016, 27-31
- **HOU ZHOU et al.** Cycle analysis of time-invariant LDPC convolutional codes. *Proc. 17th International Conference on Telecommunications (ICT) 2010,* 04 April 2010, 23-28